# EUROPÄISCHE PATENTSCHRIFT

(11) **EP 2 005 486 B1**
(45) Veröffentlichungstag und Bekanntmachung des Hinweises auf die Patenterteilung: **20.10.2010**
(21) Anmeldenummer: 07727777.0
(22) Anmeldetag: 04.04.2007
(51) Int. Cl.: H01L 31/048, H01R 13/629, H01R 13/24

(54) **Elektrische Anschlussvorrichtung für Flachleiter**
Electrical connecting device for flat conductors
Dispositif de connexion électrique pour conducteurs plats

(30) Priorität: 13.04.2006 DE 102006017969
(43) Veröffentlichungstag der Anmeldung: 24.12.2008
(73) Patentinhaber: Weidmüller Interface GmbH & Co. KG, 32758 Detmold (DE)
(72) Erfinder: BÖNSCH, Matthis, 33659 Bielefeld (DE); BECK, Thorsten, 34454 Bad Arolsen-wetterburg (DE); SCHILD, Wolfgang, 32049 Herford (DE)
(74) Vertreter: Dantz, Jan Henning
(86) Internationale Anmeldenummer: PCT/EP2007/053306
(87) Internationale Veröffentlichungsnummer: WO 2007/118798

(56) Entgegenhaltungen:
- DE-U1- 20 311 183
- DE-U1-202005 018 884

## Beschreibung

Die Erfindung betrifft eine Anschlußvorrichtung für Leiterenden, insbesondere Messerkontakte, an Photovoltaikanlagen nach dem Oberbegriff des Anspruchs 1.

Photovoltaikanlagen weisen in der Regel wenigstens ein Photovoltaikpaneel zur Stromerzeugung aus Sonnenlicht auf. Dabei sind in der Regel flexible Flachleiter aus den Photovoltaikpaneelen herausgeführt, die es ermöglichen, die Photovoltaikpaneele - in der Regel über ein Mehrleiterkabel - beispielsweise an eine Hausinstallation oder zunächst an elektrische Geräte wie einen Wechselrichter oder dgl. anzuschließen.

Dabei ist es der Stand der Technik, die einzelnen Flachleiter mittels Einzelklemmen oder dgl. von Hand zu kontaktieren. Aus diesem Grund ist der Anschluss der Geräte relativ mühsam und es ist in der Regel notwendig, zum Anschluss der Geräte besonders geschulte Fachkräfte einzusetzen.

Ergänzend besteht das Problem, dass die derart erstellten Installationen in der Regel relativ unübersichtlich sind und von daher im Störungsfall auch nur schwer instand zu setzen sind.

Es sind auch gattungsgemäße Anschlussvorrichtungen mit einem Aufnahmegehäuse für die Flachleiterenden bekannt, mit welchen die Leiterenden kontaktiert werden (DE 20 2005 018 884 U1). Zum Stand der Technik werden ferner die US 4,460232 und die DE 203 11 183 U1 genannt.

Vor diesem Hintergrund ist es die Aufgabe der Erfindung, eine Anschlußvorrichtung bzw. eine Anschlusseinrichtung für Flachleiter zu realisieren, mit der auf einfachere Weise als nach dem Stand der Technik eine Kontaktierung der Flachleiter und deren . Anschluss an ein übergeordnetes Gerät oder System realisierbar ist.

Die Erfindung löst diese Aufgabe durch den Gegenstand des Anspruchs 1.

Vorteilhafte Ausgestaltungen sind den Unteransprüchen zu entnehmen.

Sie schafft auch den Gegenstand des Anspruchs 30.

Anspruch 1 beschreibt eine Anschlussvorrichtung für Leiterenden, insbesondere Flachleiterenden an einem Photovoltaikpaneel, aus dem eine Mehrzahl der Flachleiterenden vorsteht, und die ein Aufnahme- bzw. Anschlussgehäuse aufweist, gekennzeichnet durch eine auf dem Photovoltaikpaneel anbringbare, insbesondere aufklebbare Aufnahmeeinheit zur Aufnahme der Flachleiterenden, auf welche das Aufnahmegehäuse aufsetzbar ist.

Derart werden die Flachleiterenden nach Art eines ersten Montageschrittes bzw. einer Vormontage an der Aufnahmeeinheit festgelegt, die dann leichter als vormontierte Einheit kontaktierbar ist als die bekannten Lösungen nach dem Stand der Technik.

Vorzugsweise ist die Aufnahmeeinheit als Aufnahmeträger ausgebildet, der wenigstens eine Aufnahme oder eine Mehrzahl von Aufnahmen, insbesondere Aufnahmestegen aufweist, über die jeweils eines der Flachleiterenden biegbar ist.

Dabei ist es zweckmäßig, wenn das Aufnahmegehäuse auf den Aufnahmeträger aufsteckbar, z.B. aufrastbar ist

Vorzugsweise weist die Aufnahmeeinheit Aufnahmen, insbesondere Aufnahmestege, auf, über die oder an denen jeweils eines der Flachleiterenden biegbar festlegbar ist.

Besonders bevorzugt und vorteilhaft geschieht dieses Festlegen an den Aufnahmestege, so dass aus der übergeordneten Einheit aus den Flachleiterenden auf den Aufnahmestegen und dem Aufnahmeträger quasi eine Art Stecker als Teil der Anschlussvorrichtung bzw. der Anschlusseinrichtung direkt am Photovoltaikpaneel ausgebildet wird.

Die Aufnahmestege können aus Kunststoff oder einem anderen, ggf. auch leitenden Material bestehen, sofern zwischen den Flachleiterenden eine ggf. erforderliche galvanische Trennung realisiert ist. Im Bereich jedes Aufnahmesteges werden damit aus den Flachleiterenden über den Aufnahmestegen stabile Kontakte, die ohne weiteres auch gegen größere Kräfte z.B. in einen Federkontakt (insbesondere auch in Push-In-Technik) einschiebbar sind.

Es ist vorteilhaft, über diese vormontierbare Einheit das Aufnahmegehäuse als weiteren teil der Anschlussvorrichtung zu setzen, das vorzugsweise eine abschnittsweise offene Bodenseite aufweist, so dass es über den Aufnahmeträger setzbar ist. Dieses Gehäuse bildet vorzugsweise ebenfalls einen Teil der bereits vor der Montage auf dem Dach vormontierbaren Einheit, so dass auf dem Dach nur noch das Photovoltaikpaneel mit der Box als Ganzes vorkonfektioniert und vormontiert beispielsweise an einen Wechselrichter anzuschließen ist.

Mit der Erfindung wird der Anschluss von Photovoltaikpanelen an übergeordnete Installationssysteme deutlich vereinfacht. Der Anschluss kann schneller und nach einer besonders bevorzugten Variante sogar werkzeuglos geschehen. Der Zeitaufwand wird wie die Gefahr der Fehlinstallation deutlich verringert. Zudem wird durch die übersichtliche und quasi selbsterklärende Installation auch eine leichtere Wartung und Instandhaltung der Anlage ermöglicht.

Die Aufnahmestege können miteinander fluchten oder versetzt zueinander.angeordnet sein. Es ist auch denkbar, sie sämtlichst parallel zueinander insbesondere in einer einzigen Reihe anzuordnen, da derart eine besonders schmale, aber dafür etwas längere Anschlussvorrichtung realisierbar ist.

Die Erfindung schafft auch eine Anschlussvorrichtung für Leiterenden, insbesondere Flachleiterenden an einem Photovoltaikpaneel, aus dem eine Mehrzahl der Flachleiterenden vorsteht, und die ein Aufnahme- bzw. Anschlussgehäuse aufweist, welches auf dem Photovoltaikpaneel anbringbar ist, insbesondere Anschlussvorrichtung nach einem der vorstehenden Ansprüche, wobei das Aufnahmegehäuse eine Wanne aufweist, die bis auf Öffnungen für Kabeldurchführungen für Kabel und bis auf die zum Photovoltaikpaneel weisende Seite geschlossen ausgebildet ist.

Nachfolgend wird die Erfindung unter Bezug auf die Zeichnung anhand eines Ausführungsbeispiels näher beschrieben. Es zeigt:
- Fig. 1 a-c: perspektivische Ansichten eines Randbereiches eines Photovoltaikpa- neels und die Montage eines Montagerahmens an Flachleitern in drei aufeinander folgenden Schritten;
- Fig. 2a,b: jeweils eine perspektivische Ansicht des Aufnahmegehäuses und die Montage des Aufnahme- bzw. Anschlussgehäuses an dem Montagerah- men in zwei Schritten sowie Ausschnittsvergrößerungen dieser Abbil- dungen;

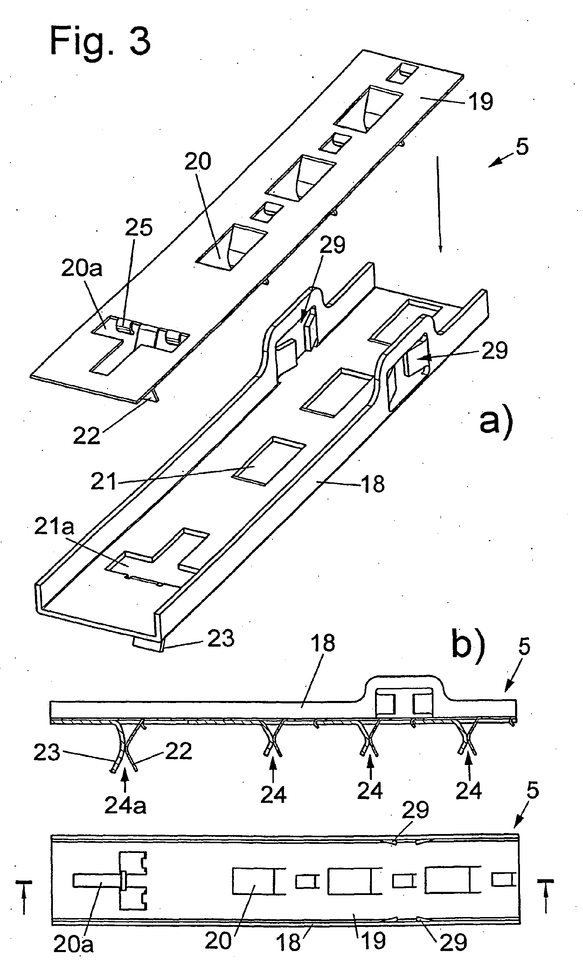

- Fig. 3a, b: Komponenten einer Anschlussschiene; und
- Fig. 4a-d: die Montage eines Anschlussgehäuses in vier Schritten;
- Fig. 5 - 9: verschiedene Ansichten eines weiteren Anschlussgehäuses;

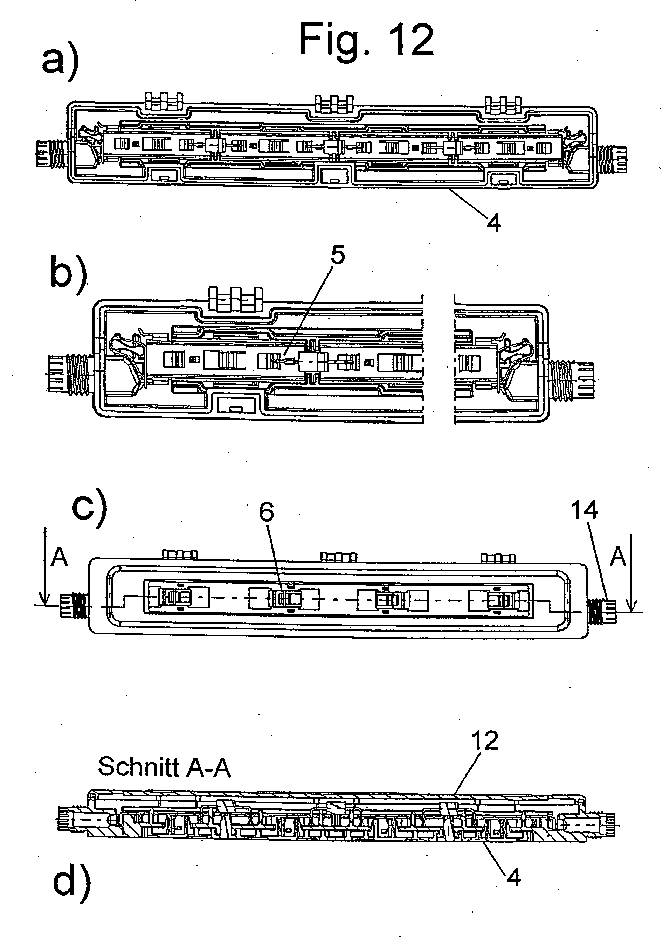

- Fig. 10 - 12: verschiedene Ansichten eines besonders schmal bauenden weiteren An- schlussgehäuses;
- Fig. 13a - e: die Montage einer weiteren Anschlussvorrichtung in fünf Schritten;
- Fig. 14 - 15: verschiedene Ansichten der Anschlussvorrichtung aus Fig. 13;

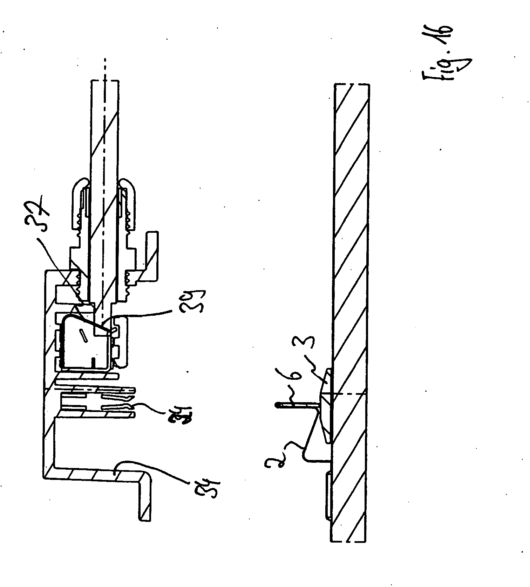

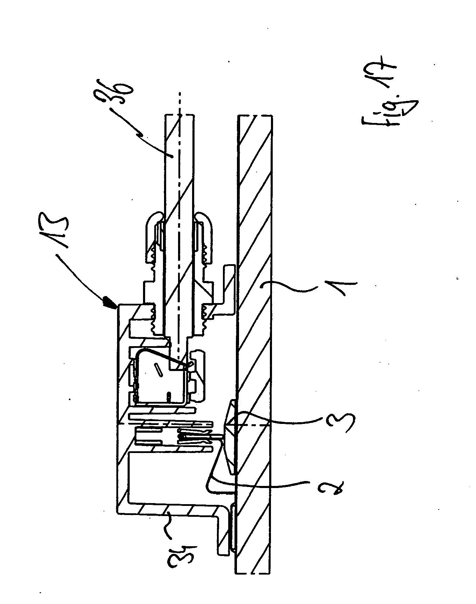

- Fig. 16 - 17: Schnittansichten zur Montage der Anschlussvorrichtung aus Fig. 13;

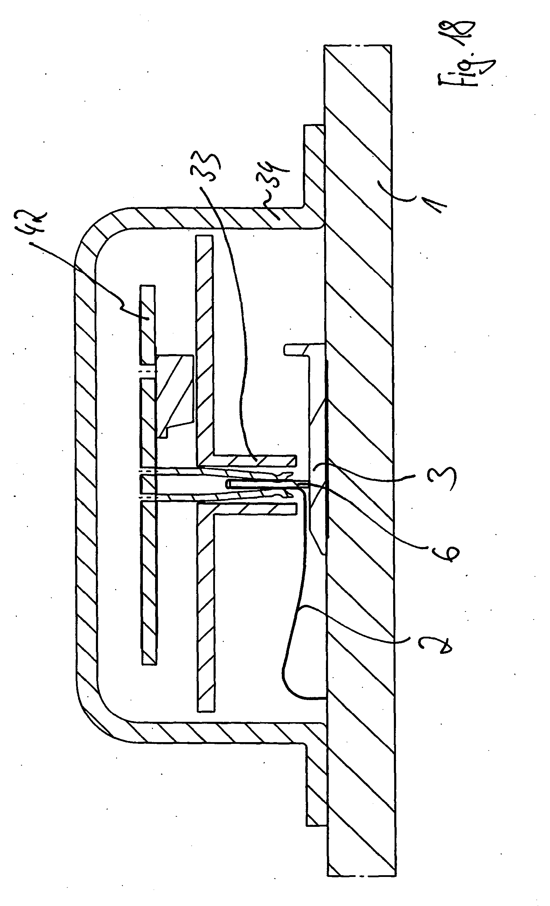

- Fig. 18: eine Schnittansicht einer weiteren Anschlussvorrichtung im installierten Zustand;
- Fig. 19: eine Sprengansicht einer weiteren Anschlussvorrichtung;
- Fig. 20: eine Sprengansichten einer weiteren Anschlussvorrichtung; und
- Fig. 21: eine Leiterplatte für das Aufnahmegehäuse aus Fig. 20.

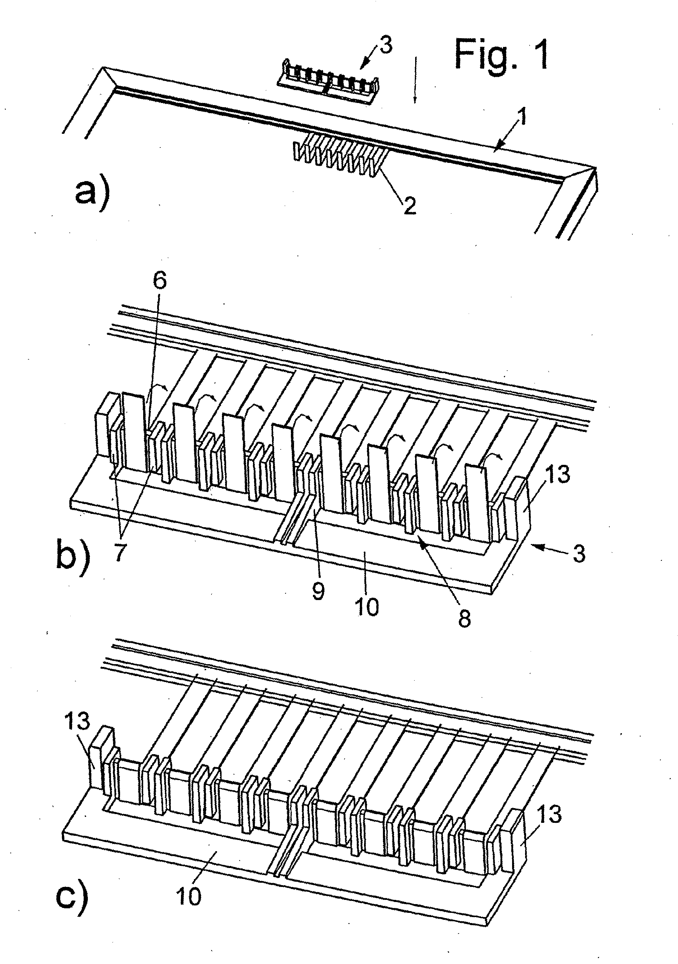

Fig. 1 zeigt ein Photovoltaikpaneel 1, aus dem eine Mehrzahl von vorzugsweise flexiblen, biegbaren Flachleiterenden 2 vorsteht, die parallel zueinander in einer Reihe ausgerichtet sind und deren Endabschnitte vom Photovoltaikpaneel 1 senkrecht nach oben umgebogen sind.

Diese Flachleiterenden 2 sind mit einer Anschlussvorrichtung zu kontaktieren. Dies geschieht an einem bzw. mittels einem Aufnahmeträger 3 für die Leiterenden 2. Dieser wird vorzugsweise einfach und schnell mittels eines Doppelklebebandes an der Rückseite des Photovoltaikpaneels befestigt.

Der Aufnahmeträger 3 weist eine Reihe von Aufnahmestegen 6 auf, die im montierten Zustand vorzugsweise senkrecht zur Oberfläche des Photovoltaikpaneels ausgerichtet sind und über die jeweils eines der Flachleiterenden 2 biegbar ist, um an den Aufnahmestegen 6 stabile Kontaktbereiche auszubilden.

Die Aufnahmestege 6 sind hier jeweils beidseits von Trennwänden 7 begrenzt, die senkrecht zu den Aufnahmestegen 6 ausgerichtet sind, so dass die Aufnahmestege 6 für die einzelnen Flachleiterenden 2 klar voneinander getrennt sind, was es ermöglicht, Fehlbeschaltungen zu vermeiden.

Die Aufnahmestege 6 können aus Kunststoff oder einem anderen Material, ggf. auch Metall, bestehen. Sie können theoretisch nahezu beliebig relativ zueinander ausgerichtet sein, so in einer oder mehreren Reihen nebeneinander oder parallel zueinander oder beispielsweise auch derart, dass sie gemeinsam auf einem Bogen liegen.

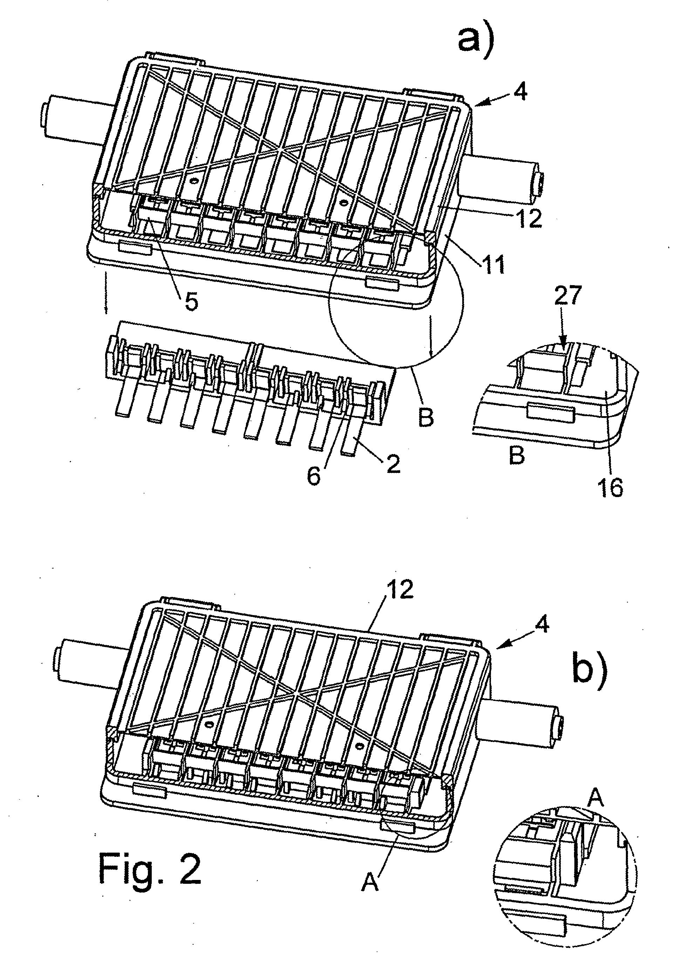

Zunächst werden die Flachleiterenden durch einen Schlitz 8 bzw. eine lang gestreckte Ausnehmung des Aufnahmeträgers 3 gesteckt (Fig. 2b)und dann jeweils über die zugeordneten Aufnahmestege 6 gebogen (Fig. 2c). Dies ist einfach und schnell realisierbar.

Der Schlitz 8 ist durch einen Stabilisierungssteg 9 in zwei Abschnitte unterteilt.

Seitlich der jeweils äußersten Trennwände 7 sind hier größere Vorzentrierungsstege 13 ausgebildet, die eine Vorzentrierung und Führung des Aufnahmegehäuses beim Aufsetzen auf den Aufnahmeträger gewährleisten und die damit auch als Fehlsteckschutz dienen.

Ein optionaler Längssteg 10 gegenüber den Aufnahmestegen 6 kann zum Halten genutzt werden und erleichtert die Handhabung.

Auf den Aufnahmeträger 3 ist ein Anschluss- bzw. Aufnahmegehäuse 4 mit einer Mehrzahl von Federklemmleisten 5 - hier in vorteilhafter als Stromschienen mit Anschlusskontakten in Direktstecktechnik (Push-In) ausgebildet - aufsetzbar, insbesondere aufsteckbar.

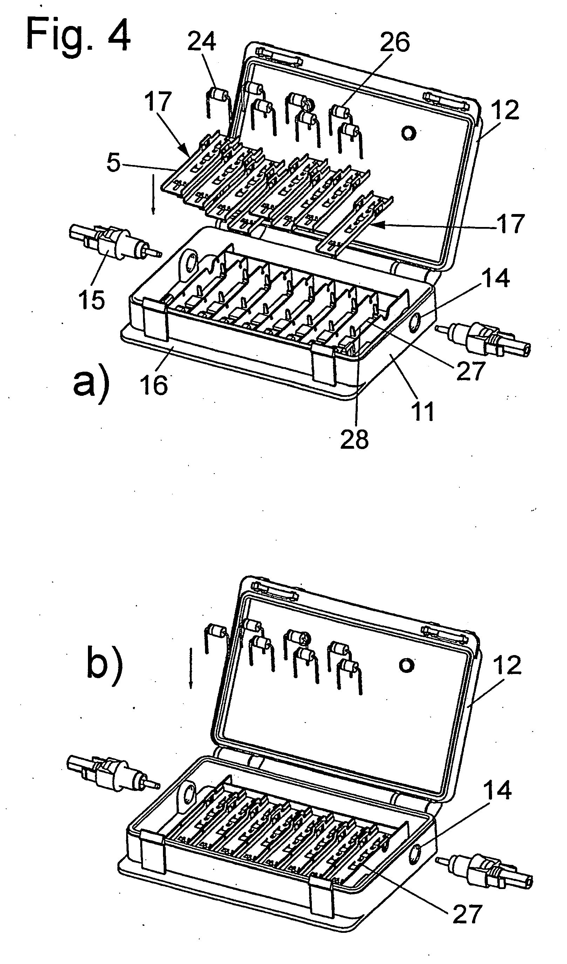

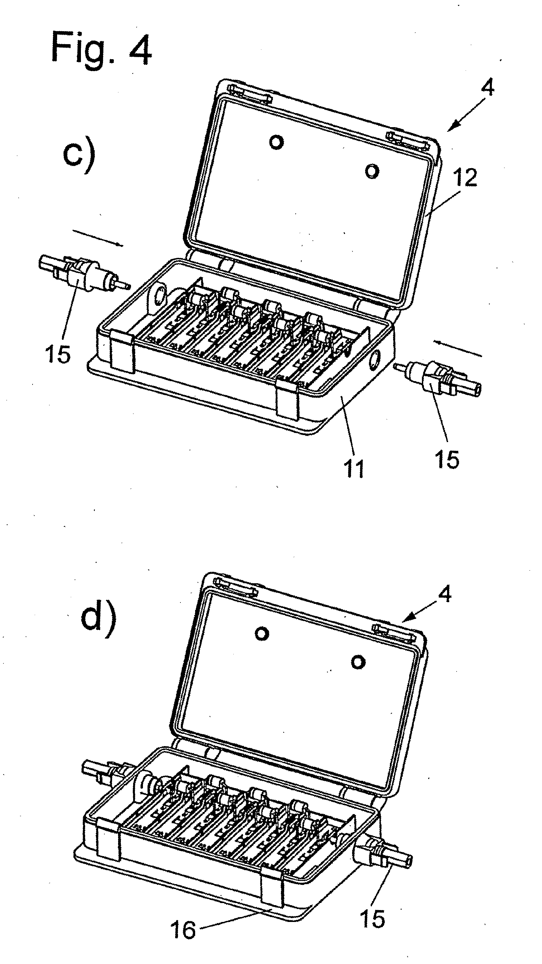

Das Aufnahmegehäuse 4 ist - siehe auch Fig. 4 - mehrteilig mit Grundteil 11 und Deckelteil 12 ausgebildet auf und weist - hier an den Seiten - Durchführungen 14 auf, die zum Beispiel zur Durchführung von Kabeln - insbesondere mit einer PG- Verschraubung geeignet sind. Alternativ können hier auch Steckvorrichtungen 15 realisiert werden, die zum Anschluss von Kabeln mit korrespondierenden Kupplungen oder direkt zum Anschluss weiterer Aufnahmegehäuse nutzbar sind. Grundteil 11 und Deckelteil 12 können schwenkbar miteinander verbunden und zum Schließen miteinander verrastbar sein (siehe Fig. 4). Dabei ist ergänzend eine transparente Ausgestaltung - auch in Teilbereichen - denkbar.

Im Inneren weist das Aufnahmegehäuse 4 Aufnahmekammern 27 auf, in die welche die Federklemmleisten 5 eingesetzt sind, die als Anschlussschienen(anordnungen) 17 ausgebildet sind. An der Bodenseite 16, mit der das Aufnahmegehäuse 4 beispielsweise auf einen seitlichen Randbereich, z.B. einen Rahmen, eines Photovoltaikpaneels aufsetzbar ist (hier nicht dargestellt), weist jede Aufnahmekammer 27 wenigstens eine Aussparung 28 auf. Die Anschlussschienen(anordnungen) 17 umfassen jeweils eine im Querschnitt u-förmigen Grundschiene 18 und eine in diese eingesetzte Deckschiene 19 (siehe hierzu Fig. 2 und in Hinsicht auf die Einbausituation auch Fig. 4).

Die Grundschiene 18 und die Deckschiene 19 weisen jeweils im montierten Zustand weitgehend fluchtende fensterartige Durchbrüche 20, 21 auf, aus denen Stege 22, 23 derart ausgebogen sind, dass die Stege 22, 23 der Grundschiene 18 und der Deckschiene 19 im montierten Zustand in ihrem Zusammenspiel jeweils tulpenartig geöffnete Federkontakte 24 ausbilden. An jeder Anschlussschiene 17 ist derart eine Mehrzahl der Federkontakte 24 ausgebildet.

Vorzugsweise besteht die eine der Stromschienen und damit der eine der Steg 22 aus einem Federblech, während die weitere Stromschiene und damit der weitere Steg 23 die Stromschienenfunktion übernimmt und insbesondere aus einer Cu-Legierung besteht. Die Federkontakte 24 bilden derart ein Push-In-Element aus. Jede Anschlussschiene 24 weist noch seitliche weitere Anschlusskontakte 29 auf, die beliebig nutzbar sind, so zur Kontaktierung einer Leitung.

An kleineren Haltestegen 25 hintergreift die Deckschiene 19 die Grundschiene 18 und ist an dieser gesichert.

Im Aufnahmegehäuse ist eine Mehrzahl von als Anschlussschienen 17 ausgebildeten Federklemmleisten 5 eingesetzt, wobei die Anzahl der Anschlussschienen 17 vorzugsweise der Anzahl der zu kontaktierenden Flachleiterenden 2 entspricht. Nach Fig. 1 sind die Federklemmleisten 5 parallel zueinander ausgerichtet.

Jeweils einer der Durchbrüche 20a, 21 a ist der Kontur des Aufnahmeträgers 3 angepasst, so dass die Aufnahmestege 6 mit den aufgebogenen Flachleiterenden 2 und die Trennwände 7 jeweils in diese Durchbrüche 20a, 21a der nebeneinander angeordneten Anschlussschienen 17 einschiebbar sind, wobei jeweils einer der Federkontakte 24a eines der Flachleiterenden 2 auf den Aufnahmestegen 6 kontaktiert. Die weiteren Federkontakte 24 sind zum Anschluss von Bauelementen wie Dioden 26 nutzbar (Fig. 4).

Dabei kann - je nach Ausgestaltung und Wunsch - auch eine mechanische Verrastung des gesamten Aufnahineträgers 3 erfolgen (hier nicht dargestellt).

Mit dem erfindungsgemäßen Aufnahme- bzw. Anschlussgehäuse 4, welches im vormontierten Zustand (Fig. 4a) am Photovoltaikpaneel vormontiert zur Baustelle geliefert wird, ist ein einfacher und insbesondere auch werkzeugfreier Anschluss des Photovoltaikpaneels an eine übergeordnete Installation z.B. eines Hauses realisierbar.

Zur eigentlichen Vormontage der Anschlussbox am Photovoltaikpaneel an sich ist zunächst notwendig, die Flachleiterenden 2 auf die Aufnahmestege 6 des Aufnahmeträgers 3 zu biegen (von Hand oder z.B. mit einer Zange) und dann das ansonsten vormontierte Aufnahmegehäuse 4 aufzusetzen. Sodann kann das Anschlussgehäuse 4 mittels Steckvorrichtungen 15 mit einer übergeordneten Schaltung verbunden werden. Ein direktes Einstecken der Flachleiterenden in das Anschlussgehäuse bzw. die dort vorgesehenen Federkontakte ist aufgrund der großen Federkräfte nicht möglich und erscheint von daher nicht sinnvoll.

An der Bodenseite 16 des Anschluss- und Aufnahmegehäuses 4 kann eine Dichtung vorgesehen sein, welche den gesamten Kontaktbereich zum Photovoltaikpaneel hin abdichtet (hier nicht dargestellt). Das gesamte Anschlussgehäuse 4 kann mit dem Photovoltaikpaneel z.B. schraubend oder auch klemmend verbunden werden.

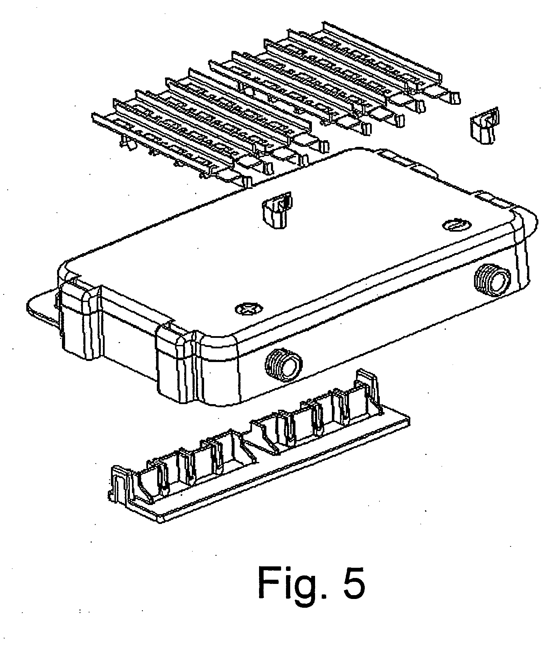

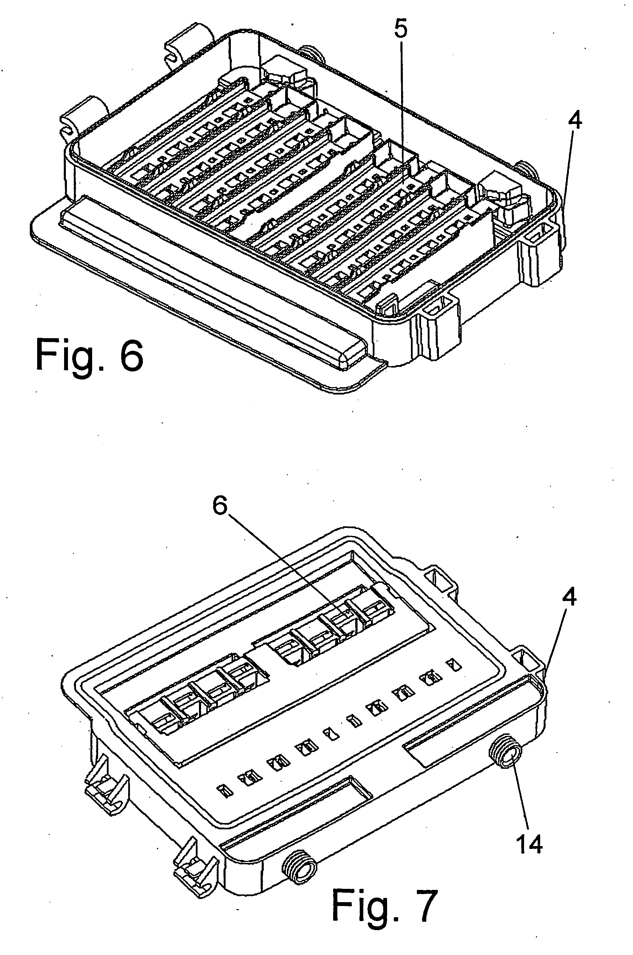

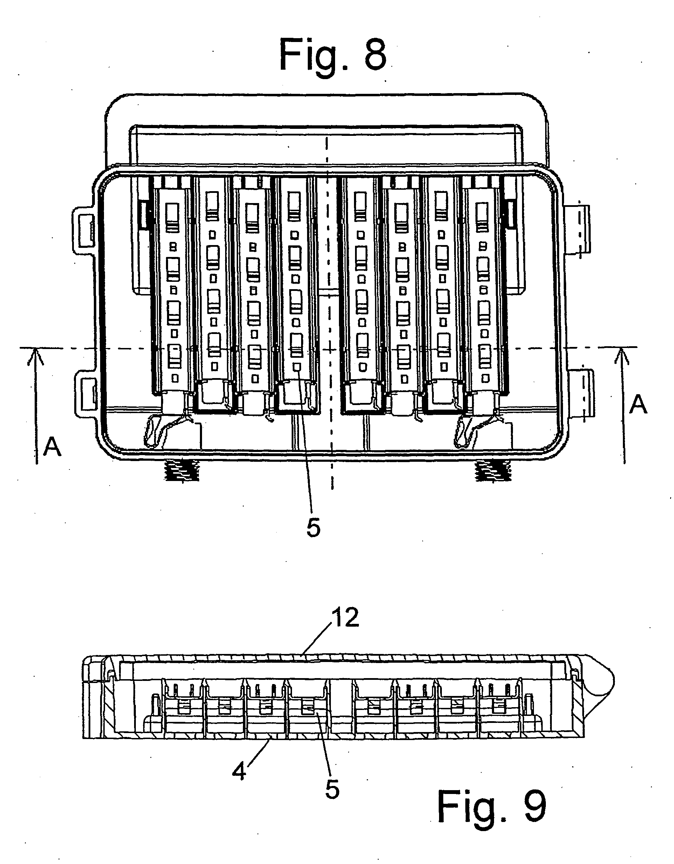

Fig. 5-9 zeigen Ansichten einer weiteren Anschlussvorrichtung mit dem Anschlussgehäuse 4 und den Aufnahmeträgern 3, wobei der Aufnahmeträger 3 der Fig. 5 - 9 Aufnahmestege 6 aufweist, die nicht in einer Reihe liegen sondern versetzt zueinander (Fig. 7). Fig. 6 zeigt das Anschlussgehäuse 4 ohne Deckel in einer Ansicht von oben und Fig. 7 die Anordnung aus Fig. 6 von unten (d.h. die auf der Kollektorrückseite aufliegende Seite).

Die Durchführungen 14 können beliebig an den übrigen Seiten verteilt sein. Optional ist an einer Öffnung eine atmungsaktive Membran zur Ableitung von Feuchtigkeit aus dem Anschlussgehäuse bzw. der Anschlussbox realisierbar (hier nicht dargestellt).

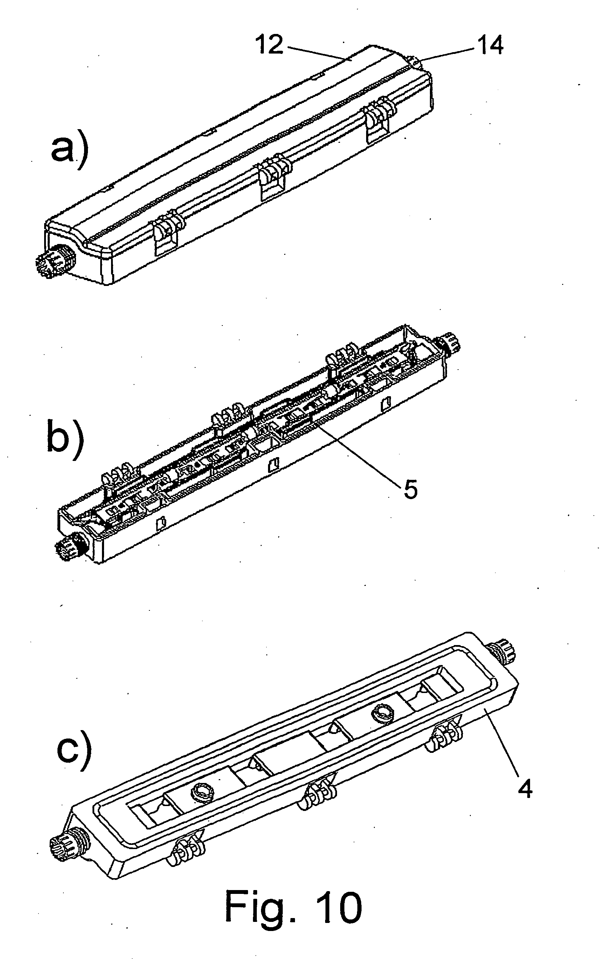

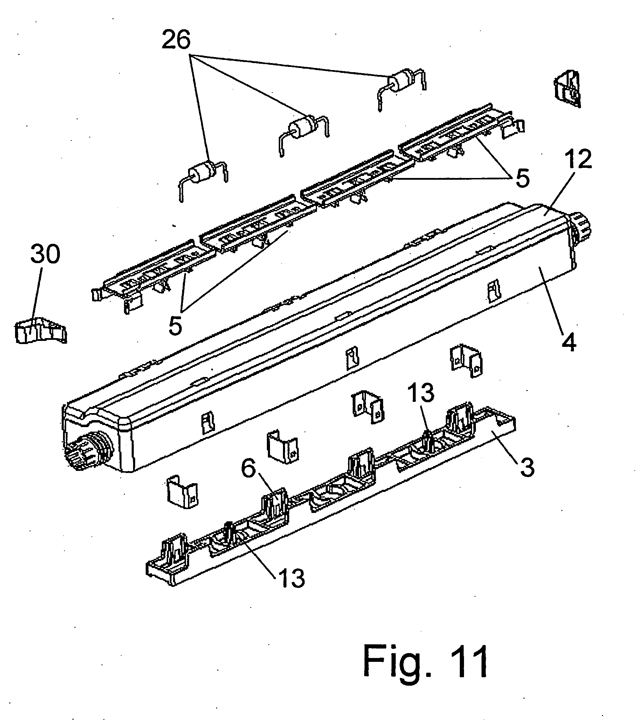

Nach Fig. 10 und 11 sind das Gehäuse 4 mit dem Deckel 12 und der Aufnahmeträger 3 mit weiter voneinander beabstandeten Aufnahmestegen 6 derart ausgebildet, dass auch die Federklemmleisten 5 - hier fluchtend - in einer Reihe angeordnet sind, so dass sich eine besonders schmale und lang bauende Ausführung ergibt. Gut zu erkennen sind wiederum die Dioden 26.

An den Enden der Federklemmleistenreihen können hier Anschlusskontakte 30, z.B. in Push-In-Technik vorgesehen sein, welche den Anschluss von anzuschließenden Leitern erlauben. Die Durchführungen 14 sind zur Realisierung einer besonders kompakten Bauform vorzugsweise an den Schmalseiten des lang gestreckten Anschlussgehäuses 4 angeordnet.

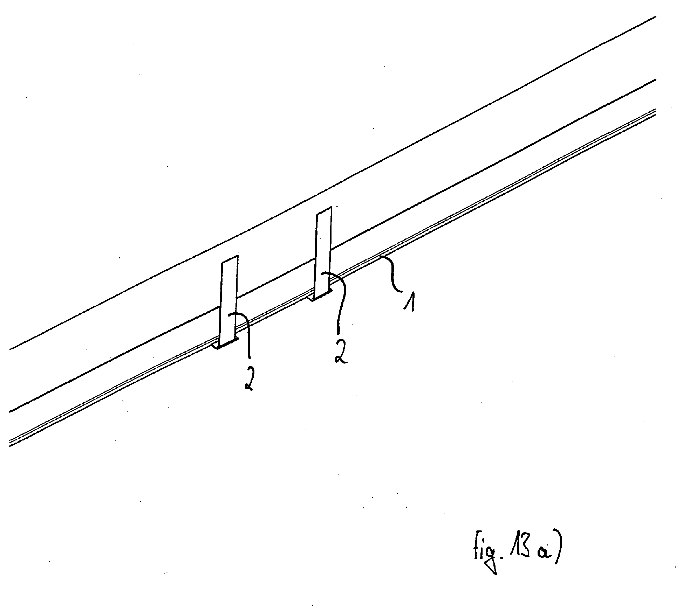

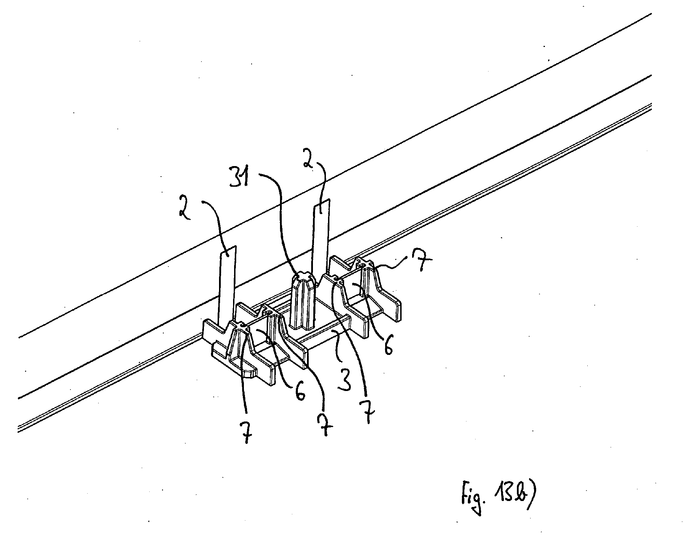

Fig. 13a - e veranschaulichen die Montage einer weiteren Anschlussvorrichtung mit einem Aufnahmegehäuse 4, das verschiedenen Komponenten aufnimmt, so den Aufnahmeträger 3, in fünf Schritten.

Aus dem Photovoltaikpaneel 1 steht wiederum eine Mehrzahl -also mindestens zwei - Flachleiterenden 2 vor, die parallel zueinander in einer Reihe ausgerichtet sind und deren Endabschnitte vom Photovoltaikpaneel 1 senkrecht nach oben umgebogen sind (Fig. 13a).

Diese Flachleiterenden 2 sind zu kontaktieren.

Zunächst wird der Aufnahmeträger 2 der Anschlussvorrichtung wiederum vorzugsweise mittels eines Doppelklebebandes an der Rückseite des Photovoltaikpaneels befestigt.

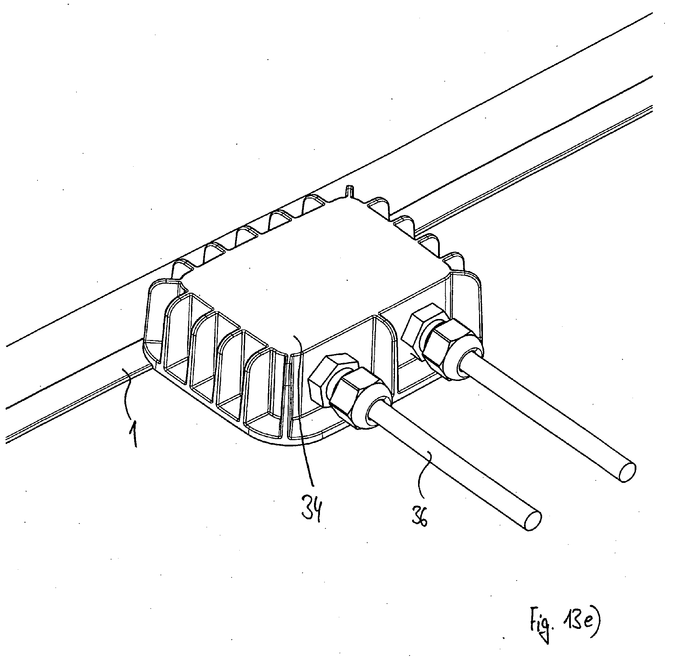

Der Aufnahmeträger 3 weist wenigstens einen Aufnahmesteg 3 oder mehrere Aufnahmestege 3 auf. Hier weist er zwei Aufnahmestege 6 auf, die im montierten Zustand vorzugsweise senkrecht zur Oberfläche des Photovoltaikpaneels ausgerichtet sind und über den/die jeweils eines der Flachleiterenden 2 biegbar ist, um an den Aufnahmestegen 6 stabile Kontaktbereiche auszubilden (Fig. 13e).

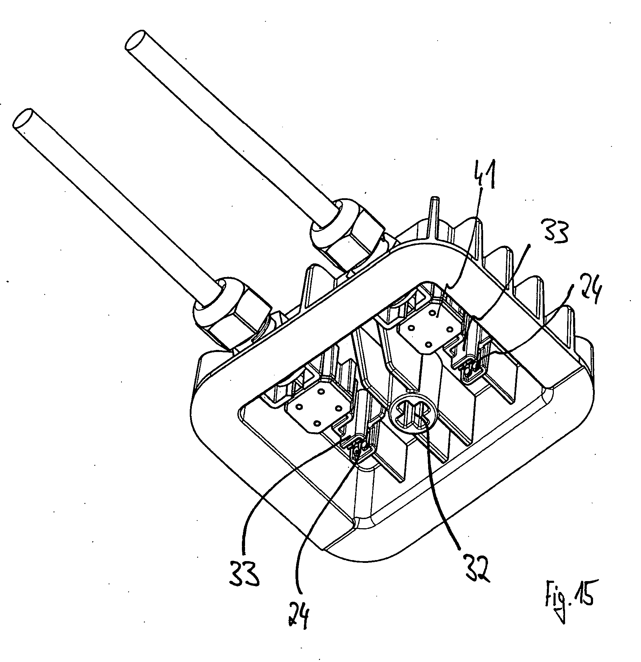

Zwischen den Aufnahmestegen 6 ist ein profilierter Zentrierdorn 31 angeordnet, der sich senkrecht vom Aufnahmeträger 3 vorsteht und zum Eingriff in eine entsprechend profilierte Aufnahme 32 am Aufnahmegehäuse ausgelegt ist (siehe auch Fig. 15).

Die Aufnahmestege 6 sind hier wiederum beidseits von Trennwänden 7 begrenzt, die senkrecht zu den Aufnahmestegen 6 ausgerichtet sind, so dass die Aufnahmestege 6 für die einzelnen Flachleiterenden 2 klar voneinander getrennt sind, was es ermöglicht, Fehlbeschaltungen zu vermeiden.

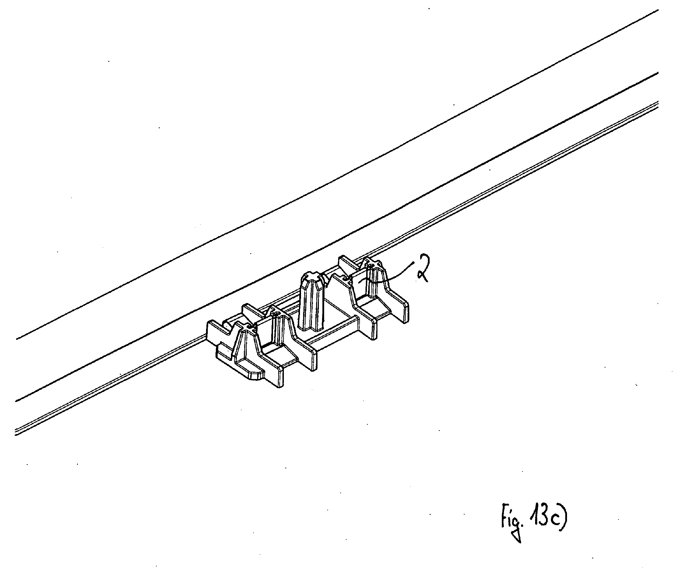

Die Flachleiterenden 2 werden hier von der Seite her über die zugeordneten Aufnahmestege 6 gebogen (Fig. 13c). Dies ist einfach und schnell realisierbar.

Der Aufnahmeträger 3 bildet einen vormontierten Teil der Anschlussvorrichtung bzw. der Komponenten, welche das Aufnahmegehäuse 4 im montierten Zustand aufnimmt.

Das Aufnahmegehäuse 4 ist mit Federkontakten 24 versehen, die vorzugsweise von einem Kragen 33 eingefasst sind und die aufgrund des 3 Aufnahmeträgers der zum Einführen der umgebogenen und derart vormontierten Flachleiterenden 2 genutzt wird, derart starke Federkräfte aufweisen können, dass ein sicherer Kontakt zu den Flachleiterenden auf den Aufnahmestegen 6 des Aufnahmeträgers 3 realisiert wird. Damit ist es zwar nach wie vor notwendig, die Flachleiterenden zur Montage zunächst über den Aufnahmeträger zu biegen, dieser zusätzliche Montagevorgang wird aber in Kauf genormen, um eine sichere Kontaktierung zu ermöglichen. Da der Aufnahmeträger vormontierbar ist, wird das Umbiegen der Leiterenden aber zumindest vereinfacht.

Da der Aufnahmeträger 3 mit einer Mehrzahl von Federkontakten 24- hier in vorteilhafter in Direktstecktechnik (Push-In) ausgebildet - ausgebildet ist, kann das übrige Aufnahmegehäuse einfach auf den Aufnahmeträger 24 aufgesetzt werden.

Das eigentliche Aufnahmegehäuse 4 ist hier einstückig als Wanne 34 geformt, die bis auf Öffnungen 40 für Kabeldurchführungen (insbesondere Schaubdurchführungen) 35 für Kabel 36 und bis auf die zum Solarpaneel 1, hier bis auf die zum Aufnahmeträger 3, weisende Seite geschlossen ausgebildet ist, so dass sie auf einfache Weise besonders dicht ist, so dass die inneren Bestandteile des Aufnahmegehäuses 4, zu denen auch der Aufnahmeträger 3 gehört, auf einfache Weise geschützt werden. Diese Erfindung ist auch in Anspruch 30 beschrieben. Sie eignet sich insbesondere - aber nicht nur - für Ausgestaltungen mit Aufnahmeträger 3. Bei Defekten wird sie vorzugsweise komplett getaucht und dann ggf. repariert.

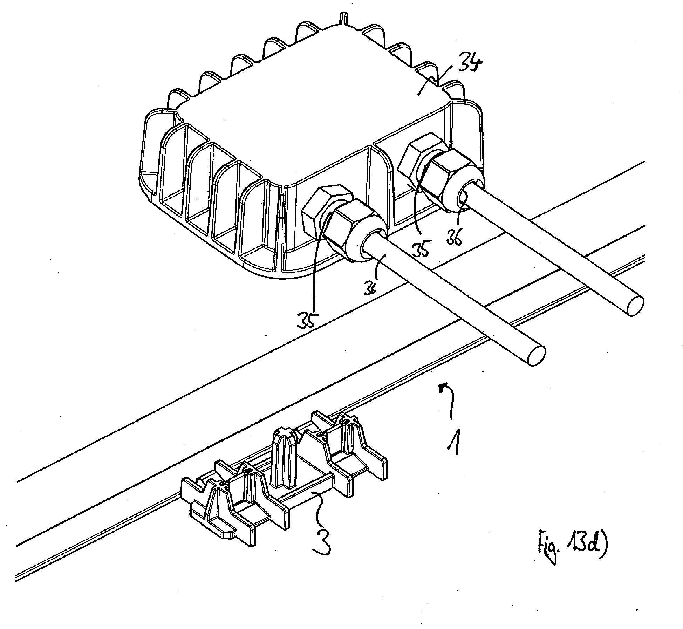

Die Montage wird durch nunmehr unmittelbar und schnell durch das Aufsetzen und ggf. Festrasten oder Festklemmen der Wanne 34 auf den Aufnahmeträger vervollständigt (Fig. 13d, 13e). Der Aufnahmeträger 3 bildet quasi ein vormontiertes. Teil des Aufnahmegehäuses 4.

Für den Endkunden wird die Anschlussvorrichtung vorzugsweise sogar bereits am Solarpaneel vormontiert geliefert. Er muß nur dann noch die Kabel 36 anschließen.

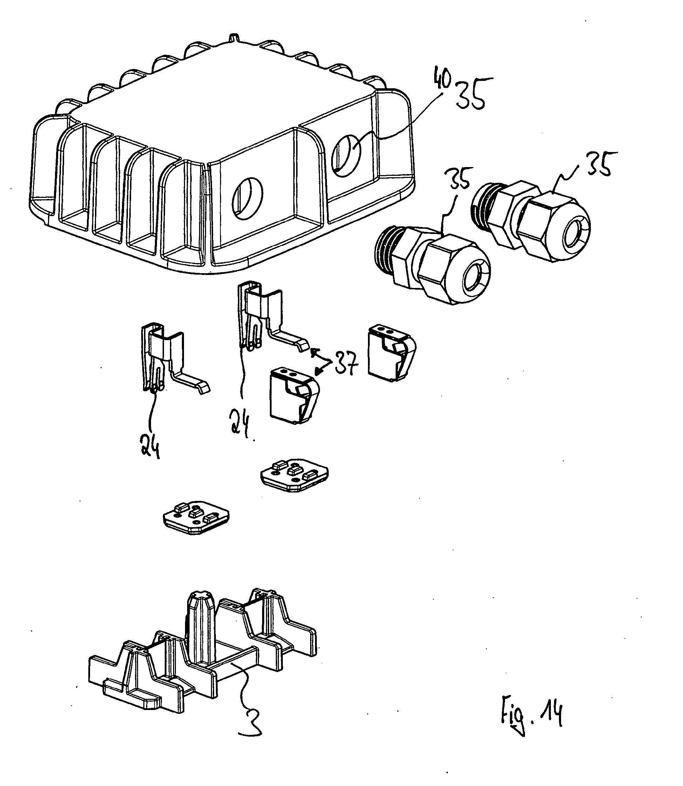

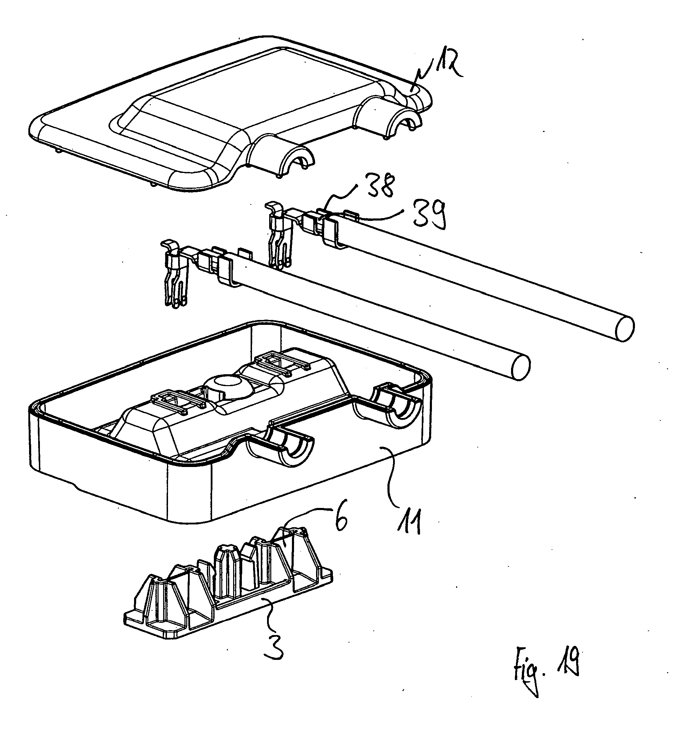

Fig. 14 veranschaulicht, dass die Wanne im montierten Zustand den Aufnahmeträger 3 aufnimmt sowie die Federkontakte 24, welche beispielsweise leitend mit weiteren Kontakten 37 (Fig. 14), beispielsweise Federkontaktmitteln 39 oder Crimpkontaktmitteln 38 (fig. 19) zur Kontaktierung der Leiterenden verbunden sind.

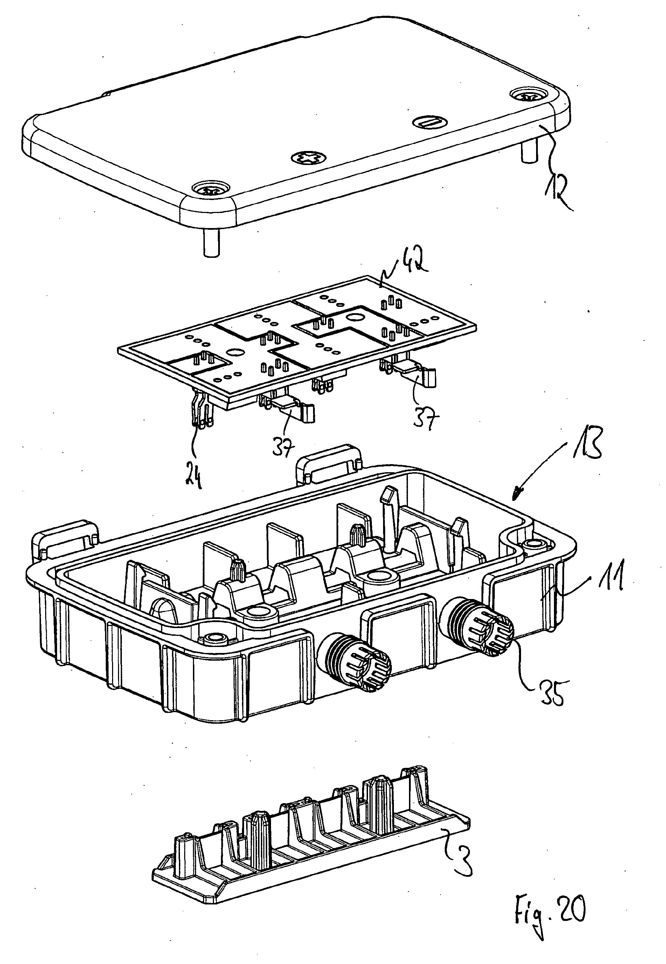

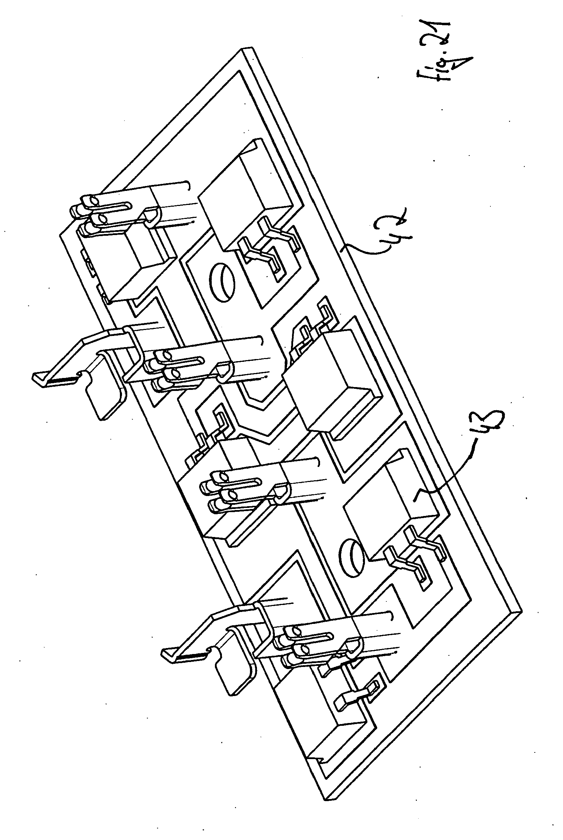

Bauelemente 43, u.a. Dioden, können auf einer oder mehreren Leiterplatten 41, 42 in dem Aufnahmegehäuse, insbesondere in der einstückigen Wanne 34, angeordnet werden (Fig. 19,20,21).

Die Leiterplatte 42 kann auch direkt die Federkontakte 24 und ggf. die Kontakte 37 aufnehmen.

Das Aufnahme- bzw. Aufnahmegehäuse 4 kann schließlich auch zur Kontaktierung mehr als zwei Flachleiterenden ausgelegt sein (Fig. 19 - 21).

Eine mehrteilige Auslegung der Wanne mit Grundteil 11 und Deckelteil 12 ist denkbar (Fig. 19)

**Bezugszeichen**
- Photovoltaikpaneel: 1
- Flachleiterenden: 2
- Aufnahmeträger: 3
- Aufnahmegehäuse: 4
- Federklemmleisten: 5
- Aufnahmestege: 6
- Trennwände: 7
- Schlitz: 8
- Stabilisierungssteg: 9
- Längssteg: 10
- Grundteil: 11
- Deckelteil: 12
- Vorzentrierungssteg: 13
- Durchführungen: 14
- Steckvorrichtungen: 15
- Bodenseite: 16
- Anschlussschienen: 17
- Grundschiene: 18
- Deckschiene: 19
- Durchbrüche: 20, 21
- Stege: 22, 23
- Federkontakte: 24
- Haltestege: 25
- Dioden: 26
- Aufnahmekammer: 27
- Aussparung: 28
- Anschlusskontakte: 29
- Anschlusskontakte: 30
- Zentrierdorn: 31
- Aufnahme: 32
- Kragen: 33
- Wanne: 34
- Kabeldurchführungen: 35
- Kabel: 36
- Kontakte: 37
- Crimpkontaktmitten: 38
- Federkontaktmittel: 39
- Öffnungen: 40
- Leiterplatten: 41,42
- Bauelemente: 43

## Patentansprüche

1. Anschlussvorrichtung für Flachleiterenden (2) an einem Photovoltaikpaneel (1), aus dem eine Mehrzahl der Flachleiterenden (2) vorsteht, und die ein Aufnahmegehäuse (4) aufweist, mit einer auf dem Photovoltaikpaneel anbringbaren Aufnahmeeinheit (3) zur Aufnahme der Flachleiterenden (2), auf welche das Aufnahmegehäuse (4) aufsetzbar ist, **dadurch gekennzeichnet, dass** die Aufnahmeeinheit als Aufnahmeträger (3) ausgebildet ist, der wenigstens eine als Aufnahmesteg (6) ausgebildete Aufnahme oder eine Mehrzahl von als Aufnahmestegen (6) ausgebildeten Aufnahmen aufweist, über den oder die jeweils eines der Flachleiterenden (2) biegbar ist.

2. Anschlussvorrichtung nach Anspruch 1, **dadurch gekennzeichnet, dass** das Aufnahmegehäuse (4) auf den Aufnahmeträger (3) aufsteckbar ist.

3. Anschlussvorrichtung nach Anspruch 2, **dadurch gekennzeichnet, dass** das Aufnahmegehäuse (4) auf den Aufnahmeträger (3) aufrastbar ist.

4. Anschlussvorrichtung nach Anspruch 2 oder 3, **dadurch gekennzeichnet, dass** das Aufnahmegehäuse (4) eine abschnittsweise offene Bodenseite (16) aufweist, so dass es über den Aufnahmeträger setzbar ist.

5. Anschlussvorrichtung nach Anspruch 3, **dadurch gekennzeichnet, dass** das Aufnahmegehäuse (4) und die Aufnahmeeinheit (3) eine am Photovoltaikpaneel vormontierte Einheit bilden.

6. Anschlussvorrichtung nach einem der vorstehenden Ansprüche 1 bis 5, **dadurch gekennzeichnet, dass** die Aufnahmestege (6) miteinander fluchtend und senkrecht zur Oberfläche des Photovoltaikpaneels ausgerichtet sind.

7. Anschlussvorrichtung nach einem der vorstehenden Ansprüche 1 bis 6, **dadurch gekennzeichnet, dass** die Aufnahmestege (6) zueinander versetzt ausgerichtet sind.

8. Anschlussvorrichtung nach einem der vorstehenden Ansprüche 1 bis 7, **dadurch gekennzeichnet, dass** die Aufnahmestege (6) parallel zueinander ausgerichtet sind.

9. Anschlussvorrichtung nach einem der vorstehenden Ansprüche 1 bis 8, **dadurch gekennzeichnet, dass** die Aufnahmestege (6) jeweils von Trennwänden (7) voneinander getrennt sind.

10. Anschlussvorrichtung nach einem der vorstehenden Ansprüche, **dadurch gekennzeichnet, dass** im Aufnahmegehäuse eine Mehrzahl von Federkontakten (24) zum Kontaktieren der Flachleiterenden (2) auf den Aufnahmestegen (6) angeordnet ist.

11. Anschlussvorrichtung nach einem der vorstehenden Ansprüche, **dadurch gekennzeichnet, dass** im Aufnahmegehäuse eine Mehrzahl von Anschlussleisten zum Kontaktieren der Flachleiterenden (2) auf den Aufnahmestegen (6) angeordnet ist.

12. Anschlussvorrichtung nach Anspruch 11, **dadurch gekennzeichnet, dass** die Anschlussleisten als Federklemmleisten (5) ausgebildet sind.

13. Anschlussvorrichtung nach Anspruch 12, **dadurch gekennzeichnet, dass** die Federklemmleisten (5) fluchtend in einer Reihe oder parallel zueinander angeordnet sind.

14. Anschlussvorrichtung nach einem der vorstehenden Ansprüche, **dadurch gekennzeichnet, dass** der Aufnahmeträger (3) einen Schlitz (8) zum Durchstecken der Flachleiterenden (2) auf die Aufnahmestege (6) aufweist.

15. Anschlussvorrichtung nach einem der vorstehenden Ansprüche, **dadurch gekennzeichnet, dass** der Aufnahmeträger (3) Vorzentrierungsstege (13) zum Aufstecken/Einstecken des Aufnahmeträgers (3) an der Bodenseite (16) des Aufnahmegehäuses (4) aufweist.

16. Anschlussvorrichtung nach Anspruch 15, **dadurch gekennzeichnet, dass** die Vorzentrierungsstege (13) zum Verrasten des Aufnahmeträgers (3) an der Bodenseite (16) des Aufnahmegehäuses (4) ausgelegt sind.

17. Anschlussvorrichtung nach einem der vorstehenden Ansprüche, **dadurch gekennzeichnet, dass** der Aufnahmeträger einen Längssteg (10) als Handhabe aufweist.

18. Anschlussvorrichtung nach einem der vorstehenden Ansprüche, **dadurch gekennzeichnet, dass** das Aufnahmegehäuse (4) mehrteilig mit Grundteil (11) und Deckelteil (12) ausgebildet ist.

19. Anschlussvorrichtung nach einem der vorstehenden Ansprüche, **dadurch gekennzeichnet, dass** am Aufnahmegehäuse (4) seitliche Durchführungen (14) für Kabel oder für Steckvorrichtungen (15) ausgebildet sind.

20. Anschlussvorrichtung nach Anspruch 18 oder 19, **dadurch gekennzeichnet, dass** das Grundteil (11) und das Deckelteil (12) schwenkbar miteinander verbunden und zum Schließen vorzugsweise miteinander verrastbar sind.

21. Anschlussvorrichtung nach einem der vorstehenden Ansprüche 13 bis 20, **dadurch gekennzeichnet, dass** das Aufnahmegehäuse (4) im Inneren Aufnahmekammern (27) aufweist, in welche die Federklemmleisten (5) eingesetzt sind.

22. Anschlussvorrichtung nach einem der vorstehenden Ansprüche 13 bis 21, **dadurch gekennzeichnet, dass** die Federklemmleisten (5) als Anschlussschienen (17) mit einer Grundschiene (18) und einer Deckschiene (19) ausgebildet sind.

23. Anschlussvorrichtung nach Anspruch 22, **dadurch gekennzeichnet, dass** die Grundschiene (18) und die Deckschiene (19) jeweils fensterartige Durchbrüche (20, 21) aufweisen, aus denen Stege (22, 23) derart ausgebogen sind, dass die Stege (22, 23) der Grundschiene (18) und der Deckschiene (19) im montierten Zustand in ihrem Zusammenspiel jeweils die tulpenartig geöffnete Federkontakte (24) ausbilden.

24. Anschlussvorrichtung nach Anspruch 22, **dadurch gekennzeichnet, dass** an jeder Anschlussschiene (17) eine Mehrzahl der Federkontakte (24) ausgebildet ist.

25. Anschlussvorrichtung nach Anspruch 24, **dadurch gekennzeichnet, dass** jeweils einer der Federkontakte (24) zur Kontaktierung von jeweils einem der Flachleiterenden (2) auf jeweils einem der Aufnahmestege (6) ausgebildet ist.

26. Anschlussvorrichtung nach einem der vorstehenden Ansprüche 24 oder 25, **dadurch gekennzeichnet, dass** die weiteren Federkontakte (24) zur Kontaktierung von Bauelementen, insbesondere Dioden (26), nutzbar sind.

27. Anschlussvorrichtung nach Anspruch 26, **dadurch gekennzeichnet, dass** die Bauelemente Dioden (26) sind.

28. Anschlussvorrichtung nach einem der vorstehenden Ansprüche 18 bis 22, **dadurch gekennzeichnet, dass** die Deckschiene (19) an Haltestegen (25) die Grundschiene (18) hintergreift und an dieser gesichert ist.

29. Anschlussvorrichtung nach Anspruch 15 bis 28, **gekennzeichnet durch** Vorzentrierungsstege (13), die derart ausgebildet sind, dass sie eine Vorzentrierung und Führung des Aufnahmegehäuses beim Aufsetzen auf den Aufnahmeträger gewährleisten.

30. Anschlussvorrichtung nach einem der vorstehenden Ansprüche, **gekennzeichnet durch** wenigstens einen vorzugsweise profilierten Zentrierdorn (31), der zum
Eingriff in eine entsprechend profilierte Aufnahme (32) am Aufnahmegehäuse ausgelegt ist.

31. Anschlussvorrichtung nach einem der vorstehenden Ansprüche, **dadurch gekennzeichnet, dass** die Flachleiterenden (2) von der Seite her über die zugeordneten Aufnahmestege (6) biegbar sind.

32. Anschlussvorrichtung nach einem der vorstehenden Ansprüche, **dadurch gekennzeichnet, dass** Bauelemente (43) wie die Dioden und ggf. die Federkontakte auf einer oder mehreren Leiterplatten (41, 42) in dem Aufnahmegehäuse (4) angeordnet sind.

33. Anschlussvorrichtung nach einem der vorstehenden Ansprüche, **dadurch gekennzeichnet, dass** das Aufnahmegehäuse eine Wanne (34) aufweist, die bis auf Öffnungen (40) für Kabeldurchführungen (35) für Kabel (36) und bis auf die zum Photovoltaikpaneel weisende Seite geschlossen ausgebildet ist.

34. Anschlussvorrichtung nach einem der vorstehenden Ansprüche, **dadurch gekennzeichnet, dass** Aufnahmeeinheit (3) zur Aufnahme der Flachleiterenden (2) auf das Photovoltaikpaneel aufklebbar ist.

## Claims

1. Connecting device for flat conductor ends (2) on a photovoltaic panel (1) from which a plurality of flat conductor ends (2) projects, which device comprises a housing (3) with a mounting unit (4) which can be fitted to the photovoltaic panel for the accommodation of the flat conductor ends (2), on mounting unit which the housing (4) can be mounted, **characterised in that** the mounting unit is designed as a mounting support (3) comprising at least one mounting designed as a mounting web (6) or a plurality of mountings designed as mounting webs (6), over each of which one of the flat conductor ends (2) can be bent.

2. Connecting device according to claim 1, **characterised in that** the housing (4) can be pushed onto the mounting support (3).

3. Connecting device according to claim 2, **characterised in that** the housing (4) can be latched to the mounting support (3).

4. Connecting device according to claim 2 or 3, **characterised in that** the housing (4) has a base side (16) which is open in sections, so that it can be fitted over the mounting support.

5. Connecting device according to claim 3, **characterised in that** the housing (4) and the mounting unit (3) form a unit which is pre-assembled on the photovoltaic panel.

6. Connecting device according to any of the preceding claims 1 to 5, **characterised in that** the mounting webs (6) are in alignment with one another and oriented at right angles to the surface of the photovoltaic panel.

7. Connecting device according to any of the preceding claims 1 to 6, **characterised in that** the mounting webs (6) are offset relative to one another.

8. Connecting device according to any of the preceding claims 1 to 7, **characterised in that** the mounting webs (6) are oriented parallel to one another.

9. Connecting device according to any of the preceding claims 1 to 8, **characterised in that** the mounting webs (6) are separated from one another by partitions (7).

10. Connecting device according to any of the preceding claims, **characterised in that** a plurality of spring contacts (24) for contacting the flat conductor ends (2) to the mounting webs (6) is provided in the housing.

11. Connecting device according to any of the preceding claims, **characterised in that** a plurality of connecting strips for contacting the flat conductor ends (2) to the mounting webs (6) is provided in the housing.

12. Connecting device according to claim 11, **characterised in that** the connecting strips are designed as spring terminal strips (5).

13. Connecting device according to claim 12, **characterised in that** the spring terminal strips (5) are aligned flush in a row or parallel to one another.

14. Connecting device according to any of the preceding claims, **characterised in that** the mounting support (3) has a slot (8) for passing the flat conductor ends (2) through onto the mounting webs (6).

15. Connecting device according to any of the preceding claims, **characterised in that** the mounting support (3) has pre-centring webs (13) for fitting the mounting support (3) onto/into the base side (16) of the housing (4).

16. Connecting device according to claim 15, **characterised in that** the pre-centring webs (13) are designed to latch the mounting support (3) to the base side (16) of the housing (4).

17. Connecting device according to any of the preceding claims, **characterised in that** the mounting support has a longitudinal web (10) designed as a handle.

18. Connecting device according to any of the preceding claims, **characterised in that** the housing (4) is a multi-part unit comprising a base part (11) and a cover part (12).

19. Connecting device according to any of the preceding claims, **characterised in that** lateral bushings (14) for cables or for plug connectors (15) are provided on the housing (4).

20. Connecting device according to claim 18 or 19, **characterised in that** the base part (11) and the cover part (12) are pivotably joined to each other and can preferably be latched to each other for closing.

21. Connecting device according to any of the preceding claims 13 to 20, **characterised in that** the interior of the housing (4) is provided with mounting chambers (27) into which the spring terminal strips (5) are installed.

22. Connecting device according to any of the preceding claims 13 to 21, **characterised in that** the spring terminal strips (5) are designed as connecting rails (17) comprising a base rail (18) and a top rail (19).

23. Connecting device according to claim 22, **characterised in that** the base rail (18) and the top rail (19) each has a window-like opening (20, 21) from which webs (22, 23) are bent out such that the webs (22, 23) of the base rail (18) and the top rail (19) in the assembled state form together the spring contacts (24) with their tulip-shaped openings.

24. Connecting device according to claim 22, **characterised in that** a plurality of spring contacts (24) is formed on each connecting rail (17).

25. Connecting device according to claim 24, **characterised in that** each spring contact (24) is designed for contacting one of the flat conductor ends (2) on one of the mounting webs (6).

26. Connecting device according to claim 24 or 25, **characterised in that** the further spring contacts (24) can be used for contacting components, in particular diodes (26).

27. Connecting device according to claim 26, **characterised in that** the components are diodes (26).

28. Connecting device according to any of the preceding claims 18 to 22, **characterised in that** the top rail (19) engages the base rail (18) from behind on locating webs (25) and is secured thereto.

29. Connecting device according to any of claims 15 to 28, **characterised by** pre-centring webs (13) which are designed such that they ensure a pre-centring and guidance of the housing while it is mounted on the mounting support.

30. Connecting device according to any of the preceding claims, **characterised by** at least one, preferably profiled, centring arbour (31) designed for engagement with a correspondingly profiled location (32) in the housing.

31. Connecting device according to any of the preceding claims, **characterised in that** the flat conductor ends (2) can be bent over the corresponding mounting webs (6) from the side.

32. Connecting device according to any of the preceding claims, **characterised in that** components (43) such as diodes and possibly the spring contacts are mounted on one or more printed circuit boards (41, 42) in the housing (4).

33. Connecting device according to any of the preceding claims, **characterised in that** the housing (4) has a trough (34) which, apart from openings for bushings (35) for cables (36) and apart from the side facing the photovoltaic panel, is closed.

34. Connecting device according to any of the preceding claims, **characterised in that** the mounting unit (3) for the accommodation of the flat conductor ends (2) can be adhesive-bonded to the photovoltaic panel.

## Revendications

1. Dispositif de branchement pour des extrémités de conducteurs plats (2) sur un panneau photovoltaïque (1), hors duquel s'avancent une pluralité d'extrémités de conducteurs plats (2), et qui comporte un boîtier de réception (4) avec une unité de réception (3), à monter sur le panneau photovoltaïque (1), laquelle est destinée à recevoir les extrémités de conducteurs plats (2) et sur laquelle peut être posé le boîtier de réception (4), **caractérisé en ce que** l'unité de réception est réalisée sous la forme de support de réception (3), qui comporte au moins un élément de réception, réalisé sous la forme d'une barrette de réception (6), ou une pluralité d'éléments de réception, réalisés sous la forme de barrettes de réception (6), au-dessus de laquelle ou desquelles l'une des extrémités de conducteurs plats (2) peut être pliée.

2. Dispositif de branchement selon la revendication 1, **caractérisé en ce que** le boîtier de réception (4) peut être enfiché sur le support de réception (3).

3. Dispositif de branchement selon la revendication 2, **caractérisé en ce que** le boîtier de réception (4) peut être encliqueté sur le support de réception (3).

4. Dispositif de branchement selon la revendication 2 ou 3, **caractérisé en ce que** le boîtier de réception (4) comporte un fond (16) ouvert par zones, de telle sorte que ledit boîtier de réception peut être posé au-dessus du support de réception.

5. Dispositif de branchement selon la revendication 3, **caractérisé en ce que** le boîtier de réception (4) et l'unité de réception (3) forment une unité préfabriquée sur le panneau photovoltaïque.

6. Dispositif de branchement selon l'une quelconque des revendications précédentes 1 à 5, **caractérisé en ce que** les barrettes de réception (6) sont alignées les unes aux autres et sont orientées perpendiculairement à la surface du panneau photovoltaïque.

7. Dispositif de branchement selon l'une quelconque des revendications précédentes 1 à 6, **caractérisé en ce que** les barrettes de réception (6) sont disposées en étant décalées les unes par rapport aux autres.

8. Dispositif de branchement selon l'une quelconque des revendications précédentes 1 à 7, **caractérisé en ce que** les barrettes de réception (6) sont orientées parallèlement entre elles.

9. Dispositif de branchement selon l'une quelconque des revendications précédentes 1 à 8, **caractérisé en ce que** les barrettes de réception (6) sont séparées respectivement les unes des autres par des cloisons (7).

10. Dispositif de branchement selon l'une quelconque des revendications précédentes, **caractérisé en ce qu'**une pluralité de contacts à ressort (24), destinés à contacter les extrémités de conducteurs plats (2) sur les barrettes de réception (6), sont disposés dans le boîtier de réception.

11. Dispositif de branchement selon l'une quelconque des revendications précédentes, **caractérisé en ce qu'**une pluralité de lames de raccordement, destinées à contacter les extrémités de conducteurs plats (2) sur les barrettes de réception (6), sont disposées dans le boîtier de réception.

12. Dispositif de branchement selon la revendication 11, **caractérisé en ce que** les lames de raccordement sont réalisées sous la forme de lames de serrage flexibles (5).

13. Dispositif de branchement selon la revendication 12, **caractérisé en ce que** les lames de serrage flexibles (5) sont alignées en une rangée ou sont disposées parallèlement entre elles.

14. Dispositif de branchement selon l'une quelconque des revendications précédentes, **caractérisé en ce que** le support de réception (3) comporte une fente (8) pour y faire passer les extrémités de conducteurs plats (2) vers les barrettes de réception (6).

15. Dispositif de branchement selon l'une quelconque des revendications précédentes, **caractérisé en ce que** le support de réception (3) comporte des ailettes de précentrage (13) pour poser/enficher le support de réception (3) sur le fond (16) du boîtier de réception (4).

16. Dispositif de branchement selon la revendication 15, **caractérisé en ce que** les ailettes de précentrage (13) sont conçues pour le blocage du support de réception (3) sur le fond (16) du boîtier de réception (4).

17. Dispositif de branchement selon l'une quelconque des revendications précédentes, **caractérisé en ce que** le support de réception comporte un rebord longitudinal (10) formant une poignée.

18. Dispositif de branchement selon l'une quelconque des revendications précédentes, **caractérisé en ce que** le boîtier de réception (4) est réalisé en plusieurs parties avec une partie de base (11) et un couvercle (12).

19. Dispositif de branchement selon l'une quelconque des revendications précédentes, **caractérisé en ce que** des passages (14) latéraux pour des câbles ou pour des connecteurs à fiches (15) sont réalisés sur le boîtier de réception (4).

20. Dispositif de branchement selon la revendication 18 ou 19, **caractérisé en ce que** la partie de base (11) et le couvercle (12) sont assemblés de manière pivotante l'un à l'autre et, en vue de la fermeture, peuvent de préférence être encliquetés l'un dans l'autre.

21. Dispositif de branchement selon l'une quelconque des revendications précédentes 13 à 20, **caractérisé en ce que** le boîtier de réception (4) contient à l'intérieur des chambres de réception (27), dans lesquelles sont posées les lames de serrage flexibles (5).

22. Dispositif de branchement selon l'une quelconque des revendications précédentes 13 à 21, **caractérisé en ce que** les lames de serrage flexibles (5) sont réalisées sous la forme de rails de branchement (17) avec un rail de base (18) et un rail de recouvrement (19).

23. Dispositif de branchement selon la revendication 22, **caractérisé en ce que** le rail de base (18) et le rail de recouvrement (19) comportent chacun des passages (20, 21) en forme de fenêtres, hors desquels sont pliées des barrettes (22, 23), de telle sorte que les barrettes (22, 23) du rail de base (18) et du rail de recouvrement (19) forment, dans la position montée en coopération les unes avec les autres, respectivement les contacts à ressort (24) ouverts en forme de tulipe.

24. Dispositif de branchement selon la revendication 22, **caractérisé en ce que** sur chaque rail de branchement (17) sont formées une pluralité de contacts à ressort (24).

25. Dispositif de branchement selon la revendication 24, **caractérisé en ce que** respectivement un des contacts à ressort (24) est réalisé pour mettre en contact respectivement une des extrémités de conducteurs plats (2) sur respectivement une des barrettes de réception (6).

26. Dispositif de branchement selon la revendication 24 ou 25, **caractérisé en ce que** les autres contacts à ressort (24) peuvent être utilisés pour mettre en contact des composants, en particulier des diodes (26).

27. Dispositif de branchement selon la revendication 26, **caractérisé en ce que** les composants sont des diodes (26).

28. Dispositif de branchement selon l'une quelconque des revendications précédentes 18 à 22, **caractérisé en ce que** le rail de recouvrement (19), au niveau d'ailettes de retenue (25), enserre de derrière le rail de base (18) ou l'immobilise contre celles-ci.

29. Dispositif de branchement selon les revendications 15 à 28, **caractérisé par** des ailettes de précentrage (13), qui sont réalisées de telle sorte qu'elles assurent un précentrage et le guidage du boîtier de réception lors de sa mise en place sur le support de réception.

30. Dispositif de branchement selon l'une quelconque des revendications précédentes, **caractérisé par** au moins un goujon de centrage (31), profilé de préférence, qui est conçu pour s'engager dans un logement (32) profilé de manière correspondante sur le boîtier de réception.

31. Dispositif de branchement selon l'une quelconque des revendications précédentes, **caractérisé en ce que** les extrémités de conducteurs plats (2) peuvent être pliées depuis le côté au-dessus des barrettes de réception (6) associées.

32. Dispositif de branchement selon l'une quelconque des revendications précédentes, **caractérisé en ce que** des composants (43), tels que des diodes et, le cas échéant, des contacts à ressort ou plusieurs plaquettes de circuits imprimés (41, 42), sont disposés dans le boîtier de réception (4).

33. Dispositif de branchement selon l'une quelconque des revendications précédentes, **caractérisé en ce que** le boîtier de réception (4) comporte une cuve (34) qui est fermée à l'exception des ouvertures (40) pour des passe-câble (35) pour des câbles (36) et à l'exception du côté orienté vers le panneau photovoltaïque.

34. Dispositif de branchement selon l'une quelconque des revendications précédentes, **caractérisé en ce que** l'unité de réception (3) destinée à recevoir les extrémités de conducteurs plats (2) peut être collée sur le panneau photovoltaïque.
